(19) Europäisches Patentamt
European Patent Office
Office européen des brevets

(11) Numéro de publication : **0 332 547 B1**

(12) **FASCICULE DE BREVET EUROPEEN**

(45) Date de publication du fascicule du brevet :
**03.02.93 Bulletin 93/05**

(51) Int. Cl.$^5$ : **G01R 19/00, G01R 19/32**

(21) Numéro de dépôt : **89420083.1**

(22) Date de dépôt : **07.03.89**

(54) **Circuit de mesure d'un courant.**

(30) Priorité : **07.03.88 FR 8803239**

(43) Date de publication de la demande :
**13.09.89 Bulletin 89/37**

(45) Mention de la délivrance du brevet :
**03.02.93 Bulletin 93/05**

(84) Etats contractants désignés :
**DE FR GB IT NL**

(56) Documents cités :
**ELECTRONIC DESIGN, vol. 34, no. 4, 20 février
1986, pages 59-60, Hasbrouck Heights, NJ.,
US; F. GOODENOUGH: "MOSFET measurescurrent with no loss"
J. MARKUS: "Modern electronic circuits reference manual", 1980, page 246, McGraw-Hill
Book Co., New York, US**

(73) Titulaire : **SGS-THOMSON
MICROELECTRONICS S.A.
7, Avenue Galliéni
F-94250 Gentilly (FR)**

(72) Inventeur : **Nadd, Bruno
Le Pigeonnier du Plan
F-84160 Lourmarin par Cadenet (FR)**

(74) Mandataire : **de Beaumont, Michel
1bis, rue Champollion
F-38000 Grenoble (FR)**

**Description**

La présente invention concerne le domaine des circuits intégrés de type MOS (métal-oxyde-semiconducteur).

Dans de tels circuits, on cherche souvent à mesurer un courant, par exemple pour provoquer une action en réponse à cette mesure. Une difficulté consiste à mesurer le courant sans le perturber et sans être sensible à des fluctuations de paramètres physiques, telles que des variations de température ou des variations dans le procédé de fabrication du circuit intégré.

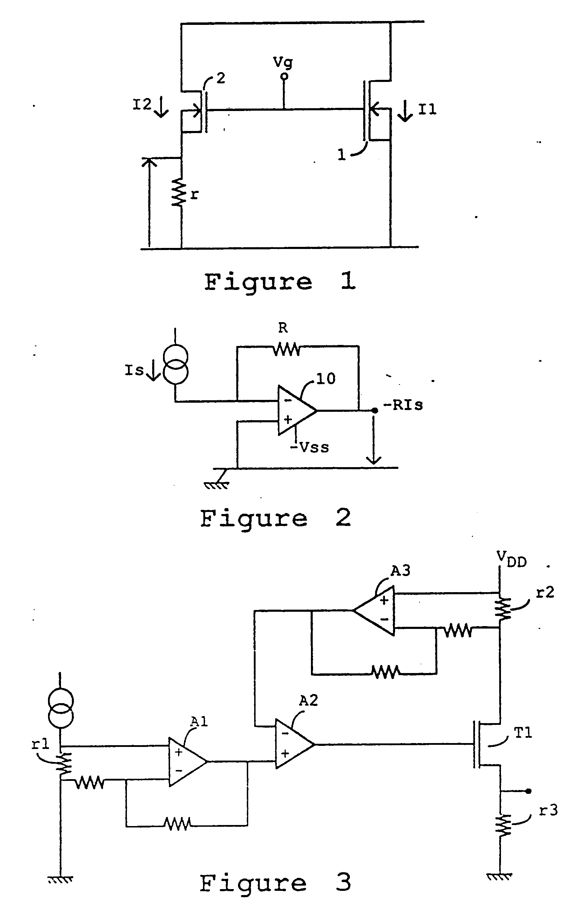

Un exemple des problèmes qui peuvent se poser va être illustré dans le cadre d'une application particulière en relation avec la figure 1. Etant donné un transistor MOS de puissance 1 de type DMOS, celui-ci est généralement réalisé technologiquement sous forme d'un très grand nombre $N_p$ de cellules identiques en parallèle. On peut réserver un certain nombre $N_s$ de cellules formant un transistor MOS 2 pour les disposer en série avec une résistance de mesure r. La tension aux bornes de cette résistance fournit une indication de la valeur du courant dans le transistor MOS 2 qui reçoit la même tension de grille $V_g$ que le transistor MOS principal. Ce courant est normalement proportionnel dans le rapport $N_s/N_p$ au courant principal. En fait il n'en est rien car la résistance r pertube le fonctionnement. On a donc en fait, en appelant $V_1$ la tension grille-source du transistor 1 et $V_2$ la tension grille-source du transistor 2 :

$$V_1 = V_2 + rI_2$$

En d'autres termes,

$$I_1/N_p g_m = (I_2/g_m + N_s rI_2)/N_s$$
$$I_2/I_1 = (N_s/N_p)(1 + N_s g_m r)^{-1}$$

Dans ces équations, $g_m$ désigne la transconductance des transistors DMOS. On voit que, quand on détecte la tension aux bornes de la résistance r, pour déterminer $I_2$, on ne peut pas en déduire directement $I_1$ car il faut pour cela connaître $g_m$. On pourrait tenir compte de ce facteur de correction et avoir une relation sensiblement linéaire quand r est faible. Toutefois, le terme de transconductance $g_m$ est sensible aux variations des procédés de fabrication et à la température. On n'obtient donc pas un détecteur fiable.

Le problème qui se pose dans ce cas particulier, et dans de nombreux cas de mesure de courants faibles, est de permettre la mesure sans introduire de perturbations et notamment de perturbations dépendant de paramètres physiques susceptibles de varier.

Ce problème a été abordé depuis longtemps et diverses solutions ont été proposées dans la technique. Plus généralement, si l'on considère le courant fourni par le transistor MOS 2 comme provenant d'une source de courant $I_s$, une première solution est illustrée en figure 2. Elle consiste tout simplement à connecter la source de courant à la borne inverseuse d'un amplificateur opérationnel 10 dont la borne non-inverseuse est reliée à la masse, une résistance de réaction R reliant la sortie de l'amplificateur opérationnel à son entrée inverseuse. Ainsi, la source de courant $I_s$ peut être considérée comme connectée à une masse virtuelle et son fonctionnement n'est pas perturbé par une résistance de mesure. Toutefois, ce circuit présente l'inconvénient que la tension à la sortie de l'amplificateur opérationnel 10 doit être négative $(-RI_s)$ et donc qu'il faut prévoir pour cet amplificateur opérationnel une source de polarisation négative. Cela pose toujours un problème dans des circuits intégrés où l'on cherche à minimiser le nombre de sources d'alimentation.

Un autre circuit de l'art antérieur, plus élaboré et destiné à éviter la nécessité de recourir à des sources de polarisation négatives, est illustré en figure 3. Ce circuit ne sera pas décrit en détail. On notera toutefois qu'il comprend trois étages d'amplificateurs opérationnels. L'amplificateur A1 donne à sa sortie une image de la tension aux bornes de la résistance r1. L'amplificateur A3 donne à sa sortie une image de la tension aux bornes de la résistance r2. L'amplificateur A2 polarise la grille du transistor T1 de sorte que ces deux images soient égales, c'est-à-dire que la tension aux bornes de la résistance r1 soit égale à la tension aux bornes de la résistance r2. Par suite, la tension aux bornes de la résistance r3 est proportionnelle au courant dans la résistance r1. Ce circuit présente les inconvénients qu'il est sensible aux tensions de décalage de zéro et présente une constante de temps relativement longue, de l'ordre de 2 microsecondes.

Ainsi, la présente invention vise à réaliser un circuit de mesure de courant permettant de ne pas perturber le courant que l'on détecte et d'obtenir une tension de mesure sensiblement indépendante des variations de température ou autre paramètre du circuit intégré contenant ce circuit de mesure.

Pour atteindre ces objects, la présente invention prévoit un circuit de mesure d'un courant dans un circuit intégré, comprenant :

- un amplificateur opérationnel
  . dont la borne d'entrée inverseuse est reliée à la masse par une première résistance de valeur $R_B$ et une deuxième résistance de valeur $R_2$, le point de raccordement de ces deux résistances recevant le courant à mesurer,
  . dont l'entrée non-inverseuse est polarisée par un pont diviseur comprenant une troisième résistance de valeur $R_A$ et une quatrième résistance de valeur $R_B$ connectées entre une tension d'alimentation et la masse,
  . dont la sortie est connectée à l'entrée d'un inverseur,
- un transistor MOS
  . dont la grille est reliée à la sortie de l'inverseur,
  . dont le drain est relié à la tension d'alimentation par une cinquième résistance de valeur

$R_1$ et à la première entrée de l'amplificateur opérationnel par une sixième résistance de valeur $R_A$,

. dont la source est reliée à la masse par l'intermédiaire d'une résistance de mesure de valeur $R_s$.

Dans ce circuit, les deuxième et cinquième résistances ont des valeurs faibles devant les première, troisième, quatrième et sixième résistances, et la tension de polarisation de l'amplificateur opérationnel et les caractéristiques de l'inverseur sont choisies pour que le transistor MOS soit polarisé à son seuil en l'absence de courant à mesurer, d'où il résulte que la tension de sortie est liée au courant à mesurer par la relation linéaire :

$$Vs = [(1 - K)/K][R_2/R_1][I_{NL}R_s]$$

où $K = R_B / (R_A + R_B)$ et $I_{NL}$ est le courant à mesurer.

Ainsi, on voit que la relation qui lie la tension de sortie au courant d'entrée ne fait appel qu'à des rapports de résistances, paramètres particulièrement insensibles aux diverses fluctuations de température et de conditions de fabrication dans un circuit intégré, et à la valeur de la résistance $R_s$ qui sera de préférence une résistance externe au circuit intégré pour obtenir une résistance de haute précision.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1, décrite précédemment, illustre le problème que la présente invention vise à résoudre ;

les figures 2 et 3 représentent des solutions de l'art antérieur au problème posé ; et

la figure 4 représente un circuit selon la présente invention.

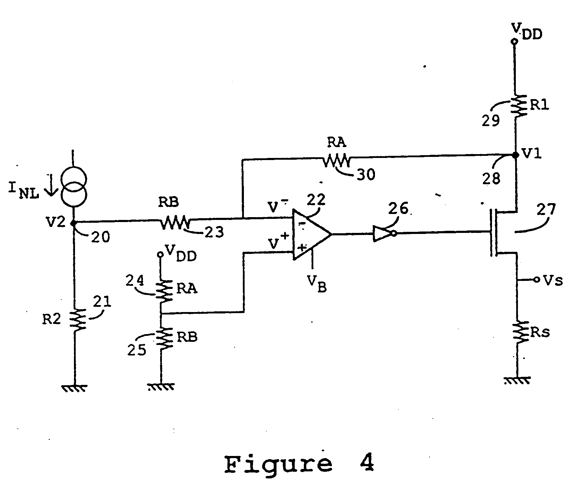

Selon la présente invention, comme cela est illustré en figure 4, la source dont on veut mesurer le courant $I_{NL}$ est reliée à une borne d'entrée 20 elle-même reliée à la masse par une résistance 21 de valeur $R_2$. La tension sur la borne 20 est appelée $V_2$. La borne 20 est reliée à l'entrée inverseuse d'un amplificateur opérationnel 22 par l'intermédiaire d'une résistance 23 de valeur $R_B$. La borne d'entrée non-inverseuse de l'amplificateur opérationnel 22 est connectée au point milieu d'un pont diviseur comprenant des résistances 24 et 25 de valeurs $R_A$ et $R_B$, la deuxième borne de la résistance 24 étant connectée à la source d'alimentation $V_{DD}$ du circuit et la deuxième borne de la résistance 25 étant reliée à la masse. L'amplificateur opérationnel reçoit en outre une tension de polarisation $V_B$. Cet amplificateur opérationnel 22 est connecté par un inverseur logique 26 à la grille d'un transistor MOS 27. L'inverseur logique 26 est un circuit fournissant un niveau haut quand son entrée reçoit un niveau bas et inversement. Le drain du transistor 27 est relié à une borne 28 elle-même reliée à la tension d'alimentation $V_{DD}$ par une résistance 29 de valeur $R_1$ et

reliée en retour à l'entrée inverseuse de l'amplificateur opérationnel 22 par une résistance 30 de valeur $R_A$. Une résistance de mesure $R_s$ est connectée entre la source du transistor MOS 27 et la masse. On obtient ainsi aux bornes de cette résistance une tension $V_S$ dont on montrera qu'elle est proportionnelle au courant $I_{NL}$.

Les valeurs de résistances $R_A$ et $R_B$ sont très élevées devant les valeurs de résistances $R_1$ et $R_2$. Par exemple, dans une réalisation pratique, les résistances $R_A$ et $R_B$ seront formées par des transistors MOS à appauvrissement et les résistances $R_1$ et $R_2$ par des zones de silicium polycristallin. Dans une technologie courante, pour une même surface de silicium, quand une résistance en silicium polycristallin aura, par exemple, une valeur de 20 ohms, une résistance constituée d'un transistor MOS à appauvrissement à grille et source reliées aura une valeur de l'ordre de quelques kilohms.

D'autre part, la tension de polarisation de l'amplificateur opérationnel 22 est réglée, en fonction de l'inverseur 26 pour que, en l'absence de courant $I_{NL}$, quand la tension $V_2$ sur la borne 20 est nulle, le transistor MOS se trouve près de son seuil de conduction. Si on appelle $I_{R1}$ le courant dans la résistance 29 de valeur $R_1$, $I_{R2}$ le courant dans la résistance 21 de valeur $R_2$, et $I_s$ le courant de mesure dans la résistance $R_s$, étant donné le choix des valeurs relatives $R_1$ et $R_2$ par rapport à $R_A$ et $R_B$, le courant $I_s$ est sensiblement égal au courant $I_{R1}$ et le courant $I_{R2}$ est sensiblement égal au courant $I_{NL}$ que l'on veut mesurer.

A l'état initial, quand $I_{NL}$ et donc $V_2$ sont égaux à zéro, étant donné que comme l'a vu précédemment la grille du transistor MOS 27 est polarisée à une valeur qui est légèrement inférieure à son seuil de conduction, la borne 28 sera au potentiel de la tension d'alimentation, c'est-à-dire que $V_1 = V_{DD}$. En outre, le potentiel $V^+$ sur l'entrée non-inverseuse du transistor MOS sera égal au potentiel $V^-$ sur l'entrée inverseuse c'est-à-dire que :

$$V^+ = V^- = V_{DD} * R_B/(R_A + R_B)$$

ou

$$V^+ = V^- = KV_{DD}, \text{ avec } K = R_B/(R_A + R_B) \quad (1)$$

Quand $I_{NL}$ commence à circuler, $V_2$ croît à la valeur $R_2I_{NL}$ ce qui amène $V^-$ à croître par rapport à $V^+$. Ceci amène alors la tension de grille du transistor 27 à croître et comme cette tension de grille se trouve initialement au seuil de conduction, du courant commence immédiatement à circuler dans le transistor MOS 27. Une augmentation du courant dans le transistor 27 amène la tension $V_1$ à chuter et la tension $V_s$ à croître. Le fait que $V_1$ a décru contrebalance l'augmentation de $V^-$ provoquée par $V_2$ et l'on arrive à nouveau à un état d'équilibre où $V^+ = V^-$. Le courant $I_s$ dans la résistance 29 ($R_1$), le transistor 27 et la résistance $R_s$ est donc lié à présence ou à l'absence d'un courant $I_{NL}$ dans la résistance 21 ($R_2$). On peut simplement établir en partant de la relation (1) ci-des-

sus que :
$$K(V_{DD} - R_1 I_s) + (1 - K)R_2 I_{NL} = K V_{DD}$$
ou
$$I_s = I_{NL}(R_2/R_1)[(1 - K)/K],$$
c'est-à-dire
$$V_s = (I_{NL} R_s)(R2/R1)[(1 - K)/K].$$

On voit donc que la tension de sortie est une fonction linéaire du courant d'entrée dans le détecteur et ne dépend de celui-ci que par des rapports de résistances et par la valeur de la résistance $R_s$. Ces rapports de résistances peuvent être très précis et la résistance $R_s$ sera de préférence une résistance de précision externe au circuit intégré.

## Revendications

1. Circuit de mesure d'un courant dans un circuit intégré, caractérisé en ce qu'il comprend :
   - un amplificateur opérationnel (22)
     . dont la borne d'entrée inverseuse est reliée à la masse par une première résistance (23) de valeur $R_B$ et une deuxième résistance (21) de valeur $R_2$, le point de raccordement de ces deux résistances recevant le courant ($I_{NL}$) à mesurer,
     . dont l'entrée non-inverseuse est polarisée par un pont diviseur comprenant une troisième résistance (24) de valeur $R_A$ et une quatrième résistance (25) de valeur $R_B$ connectées entre une tension d'alimentation et la masse,
     . dont la sortie est connectée à l'entrée d'un inverseur (26),
   - un transistor MOS (27)
     . dont la grille est reliée à la sortie de l'inverseur,
     . dont le drain est relié à la tension d'alimentation par une cinquième résistance (29) de valeur $R_1$ et à la première entrée de l'amplificateur opérationnel par une sixième résistance (30) de valeur $R_A$,
     . dont la source est reliée à la masse par l'intermédiaire d'une résistance de mesure de valeur $R_s$,
     en ce que les deuxième et cinquième résistances ont des valeurs faibles devant les première, troisième, quatrième et sixième résistances, et
     en ce que la tension de polarisation de l'amplificateur opérationnel et les caractéristiques de l'inverseur sont choisies pour que le transistor MOS soit polarisé à son seuil en l'absence de courant à mesurer,
     d'où il résulte que la tension de sortie est liée au courant à mesurer par la relation linéaire :
     $$V_s = [(1 - K)/K][R_2/R_1][I_{NL} R_s]$$
     où $K = R_B / (R_A + R_B)$.

2. Circuit de mesure d'un courant selon la revendication 1, caractérisé en ce que les résistances de valeur élevée sont réalisées au moyen de transistors MOS à appauvrissement ayant leurs sources reliées à leur grille et les résistances de valeur faible sont constituées de résistances en silicium polycristallin.

3. Circuit de mesure d'un courant selon la revendication 1 ou 2, caractérisé en ce que la résistance de mesure ($R_s$) est externe au circuit intégré.

## Patentansprüche

1. Strommeßschaltung für einen integrierten Schaltkreis, **gekennzeichnet** durch
   - einen Operationsverstärker (22),
   dessen invertierender Eingangsanschluß über einen ersten Widerstand (23) mit einem Wert $R_B$ und einen zweiten Widerstand (21) mit einem Wert $R_2$ geerdet ist, wobei am Verknüpfungspunkt der beiden Widerstände der zu messende Strom ($I_{NL}$) anliegt,
   dessen nicht invertierender Eingang durch einen zwischen einer Versorgungsspannung und Masse angeschlossenen Spannungsteiler mit einem dritten Widerstand (24) mit einem Wert $R_A$ und einem vierten Widerstand (25) mit einem Wert $R_B$ vorgespannt ist, und dessen Ausgang mit dem Eingang eines Inverters (26) verbunden ist,
   - einen MOS-Transistor (27),
   dessen Gate mit dem Inverterausgang verbunden ist,
   dessen Drain über einen fünften Widerstand (29) mit einem Wert $R_1$ mit der Versorgungsspannung und über einen sechsten Widerstand (30) mit einem Wert $R_A$ mit dem ersten Eingang des Operationsverstärkers verbunden ist, und
   dessen Source über einen Messwiderstand mit einem Wert $R_s$ geerdet ist, wobei der zweite und der fünfte Widerstand kleinere Werte haben als der erste, der dritte, der vierte und der sechste Widerstand,
   wobei die Vorspannung des Operationsverstärkers und die Eigenschaften des Inverters so gewählt sind, daß der MOS-Transistor ohne einen zu messenden Strom bei seiner Schwellspannung vorgespannt ist, und wobei die Ausgangsspannung mit dem zu messenden Strom über die lineare Beziehung:
   $$V_s = [(1 - K)/K][R_2/R_1][I_{NL}/R_S]$$
   verknüpft ist, wobei $K = R_B/(R_A + R_B)$ gilt.

2. Strommeßschaltung nach Anspruch 1, dadurch **gekennzeichnet**, daß die hochohmigen Widerstände durch MOS-Verarmungstransistoren realisiert sind, deren Sources mit deren Gate verbunden sind, und daß die niederohmigen Widerstände von polykristallinen Siliciumwiderständen gebildet sind.

3. Strommeßschaltung nach Anspruch 1 oder 2, dadurch **gekennzeichnet**, daß der Messwiderstand ($R_S$) ausserhalb des integrierten Schaltkreises angeordnet ist.

**Claims**

1. A current measuring circuit for an integrated circuit, characterized in this that it comprises:
   - an operational amplifier (22)
      . the inverting input terminal of which is grounded through a first resistor (23) having a value $R_B$ and a second resistor (21) having a value $R_2$, the junction of said two resistors receiving the current ($I_{NL}$) to be measured,
      . the non-inverting input which is biased by a dividing bridge comprising a third resistor (24) having a value $R_A$ and a fourth resistor (25) having a value $R_B$ connected between a supply voltage and the ground,
      . the output of which is connected to the input of an inverter (26),
   - a MOS transistor (27)
      . the gate of which is connected to the inverter output,
      . the drain of which is connected to the supply voltage through a fifth resistor (29) having a value $R_1$ and to the first input of the operational amplifier through a sixth resistor (30) having a value $R_A$,
      . the source of which is grounded through a measurement resistor having a value Rs,
   the second and fifth resistors having low values with respect to the first, third, fourth and sixth resistors,
   the biasing voltage of the operational amplifier and the characteristics of the inverter being chosen so that the MOS transistor is biased at its threshold in the absence of a current to be measured,
   whereby the output voltage is correlated with the current to be measured by the linear relation:
   $$Vs = [(1 - K)/K][R_2/R_1][I_{NL}/R_S]$$
   where $K = R_B/(R_A + R_B)$.

2. A current measuring circuit according to claim 1, characterized in this that the resistors having a high value are realized by means of depletion MOS transistors, the sources of which are connected to their gate and wherein the low value resistors are constituted by polycrystalline silicon resistors.

3. A current measuring circuit according to claim 1 or 2, characterized in this that the measuring resistor ($R_S$) is external to the integrated circuit.

Figure 1

Figure 2

Figure 3

Figure 4